# EUROPEAN PATENT APPLICATION

(11) **EP 2 053 663 A1**
(43) Date of publication of application: **29.04.2009**
(21) Application number: 07020927.5
(22) Date of filing: 25.10.2007
(51) Int. Cl.: H01L 31/18, H01L 21/677, C23C 16/54, B65H 23/24

(54) **Hover cushion transport for webs in a web coating process**

(71) Applicant: Applied Materials, Inc., Santa Clara, CA 95054 (US)
(72) Inventor: Buschbeck, Wolfgang, 63454 Hanau (DE)
(74) Representative: Zimmermann, Gerd Heinrich

(57) **Abstract**

The invention relates to web guiding, more particular, to web guiding. A guiding device for contact-free guiding a web is provided with the device having a surface for facing the web and a multitude of gas outlets disposed in the surface and adapted for providing a hover cushion for the web. Further, an apparatus for coating a web and a method for contact-free guiding a web is provided that comprises moving the web over a surface; and emitting a multitude of gas streams from the surface thereby generating a hover cushion between the surface and the web. Further, a method for producing a thin-film solar cell is provided that comprises a method for contact-free guiding a web according to embodiments described herein. The method for producing a thin-film solar cell further comprises depositing a back contact on the web and depositing a transparent and conductive oxide layer.

## Description

### FIELD OF THE INVENTION

The invention generally relates to thin-film forming apparatuses and methods. In particular, it relates to devices and methods for web guiding and/or cooling of webs during thin-film forming. More specifically, it relates to devices and methods for web guiding in the production processes of thin-film solar cells.

### BACKGROUND OF THE INVENTION

In apparatuses and methods for coating a web such as in the production of thin-film solar cells it is necessary to guide the web. This may be due to the fact that the moving direction of the web has to be changed. Another possible application of guiding the web is where the front side of the web is coated and the rear side of the web has to be backed. For these examples and other applications it is known to provide rollers and drums that allow for changing the moving direction of the web and/or backing the web.

However, in many applications, in particular in thin-film solar cell production applications, the direct contact of a coated web with rollers on the side of the web that is already coated may harm the coating. As a result, the coating apparatuses have to be designed such that the contact of the rollers with the web is exclusively on the rear side of the web. As described herein, the term "rear side of the web" relates to the side of the web that is not coated. Due to these design limitations complex moving paths have to be designed within the coating apparatuses and/or the overall path length of coating apparatuses is substantially limited.

Another problem arises in applications where a long coating path length is necessary. The term "coating path length" refers to the length along which the web has to be exposed to one or more coating device(s) such as evaporator(s). For instance, in the field of thin-film solar cell production, the coating path length for the p-doped layers and the n-doped layers can typically be in the range of 10 m. In order to back the web on distances of this range, huge drums have to be provided for guiding and backing the web during coating. As a result, the space requirements of the coating apparatuses reach a high level of inefficiency.

### SUMMARY OF THE INVENTION

In light of the above, a guiding device, a coating apparatus, a method for contact-free guiding a web, a method for coating a web, and a method for producing a thin-film solar cell as described herein are provided.

According to embodiments described herein, a guiding device for contact-free guiding a web is provided with the device having a surface for facing the web and a multitude of gas outlets disposed in the surface and adapted for providing a hover cushion for the web.

According to yet other embodiments described herein, a guiding device for contact-free guiding a web is provided with the device having a surface for facing the web and a multitude of gas outlets disposed in the surface wherein the surface is non-rotatable.

According to other embodiments described herein, an apparatus for coating a web having a guiding device according to embodiments described herein is provided.

According to yet other embodiments described herein, an apparatus for the production of amorphous silicon solar cells having a guiding device according to embodiments described herein is provided.

According to other embodiments described herein, a method for contact-free guiding a web is provided that comprises moving the web over a surface; and emitting a multitude of gas streams from the surface thereby generating a hover cushion between the surface and the web.

According to other embodiments described herein, a method for coating a web is provided that comprises a method for contact-free guiding a web according to embodiments described herein.

According to yet other embodiments described herein, a method for producing a thin-film solar cell is provided that comprises a method for contact-free guiding a web according to embodiments described herein. The method for producing a thin-film solar cell further comprises depositing a back contact on the web and depositing a transparent and conductive oxide layer.

Further advantages, features, aspects and details that can be combined with the above embodiments are evident from the dependent claims, the description and the drawings.

Embodiments are also directed to apparatuses for carrying out each of the disclosed methods and including apparatus parts for performing each described method steps. These method steps may be performed by way of hardware components, a computer programmed by appropriate software, by any combination of the two or in any other manner. Furthermore, embodiments are also directed to methods by which the described apparatus operates or by which the described apparatus is manufactured. It includes method steps for carrying out functions of the apparatus or manufacturing parts of the apparatus.

### BRIEF DESCRIPTION OF THE DRAWINGS

Some of the above indicated and other more detailed aspects of the invention will be described in the following description and partially illustrated with reference to the figures. Therein:

Figure 1A shows a schematic view of a guiding device according to embodiments described herein;

Figure 1B shows a schematic view of a guiding device according to embodiments described herein;

Figure 1C shows a schematic view of a guiding device according to embodiments described herein;

Figure 2 shows a schematic view of a guiding device according to embodiments described herein;

Figure 3 shows a schematic view of a guiding device according to embodiments described herein;

Figures 4A, 4B, and 4C show schematic views of the guiding device surface of a guiding device according to embodiments described herein, the guiding device surface having a multitude of gas outlets disposed therein;

Figure 5 shows a schematic view of a guiding device according to embodiments described herein;

Figure 6 shows a schematic view of a guiding device according to embodiments described herein;

Figure 7A shows a schematic view of an apparatus for guiding a web according to embodiments described herein;

Figure 7B shows a schematic view of an apparatus for guiding a web according to embodiments described herein; and

Figure 7C shows a schematic view of an apparatus for guiding a web according to embodiments described herein.

### DETAILED DESCRIPTION OF THE DRAWINGS

Within the following description of the drawings, the same reference numbers refer to the same components. Generally, only the differences with respect to the individual embodiments are described.

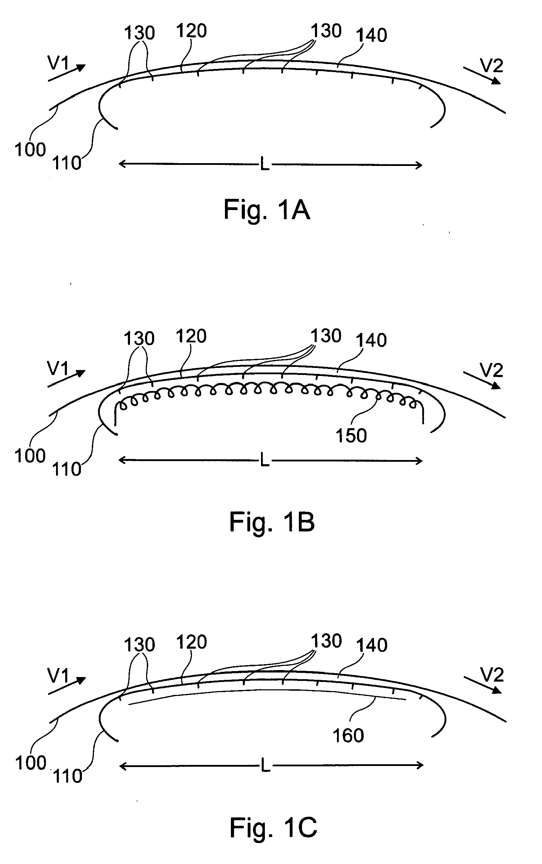

Figure 1A is schematic cross-sectional view illustrating embodiments of the guiding device. As indicated by the arrows denoted V1 and V2, the web 100 can move from the left side of the drawing to the right side. According to other embodiments, the web could also move from the right side to the left side.

A web as used within the embodiments described herein can typically be characterized in that it is bendable. The term "web" may be synonymously used to the term "strip". For instance, the web as described in embodiments herein may be a foil.

The web such as a web is guided by the guiding device 110. The guiding device comprises a guiding device surface 120 that faces the web. The term "facing" in this context refers to the situation that the surface of the guiding device is positioned and oriented such that the web moves slightly above the surface when the guiding device is in operation. In more detail, the web 100 moves on a hover cushion 140 that is generated between the surface of the guiding device and the web when gas is emitted from the multitude of gas outlets 130 disposed in the surface 120 of the guiding device 110. According to typical method embodiments described herein that are combinable with all other embodiments described herein, emitting the gas from the surface of comprises leading gas through a multitude of outlets disposed in the surface.

In many embodiments described herein, the guiding device surface of the guiding device is static, i.e. it is not adapted for being rotated. The surface is typically non-rotatable. As described herein, the terms "gas cushion" and "hover cushion" are used synonymously. According to many embodiments described herein, the hover cushion is such that there is no friction between web and surface. Typically, the web that is guided does not have any direct contact to the surface.

Typically, according to many embodiments described herein, the hover cushion generated is capable of carrying the web on the cushion. In other words, the surface of the guiding device is not in direct contact with the web when the guiding device is in operation. Instead, the web is completely carried by the hover cushion. Hence, according to typical embodiments described herein, the web can be arranged such that the coated side of the web faces the surface of the guiding device. Although the coated side may face the surface, the coated side does typically not have any direct contact with the surface.

The surface of the embodiments described with regard to Figure 1A is shown as a segment with a partly elliptic cross-section. The term "segment" of a geometrical shape such as a cylinder and/or an oval and/or an ellipse refers to only a portion of the object in the following.

In general, the guiding device surface may have a non-cylindrical shape. That is, the guiding device can be of any shape as there is typically no need for rotating it. For instance, according to different embodiments which can be combined with any of the embodiments described herein, the guiding device surface may have an oval or partly oval such as an elliptic or partly elliptic cross-section. In those embodiments, a major axis and a minor axis can be assigned to the surface shape. The length of the major axis may be up to 20 m, more typically up to 15 m, even more typically up to 10 m. The length of the minor axis is typically chosen as below 1.5 m, more typically below 1 m, even more typically below 0.5 m. In view of space requirements it is desirable to maximize the relation between major axis and minor axis. However, in order to guarantee a minimum contact pressure of the web against the surface (with the generated hover cushion therebetween), the relation between major axis and minor axis is typically limited, e.g. not larger than 20, 15, 10, or 5. As described herein, an ellipse is understood as special case of an oval in accordance with a mathematical understanding of these geometries.

Embodiments described herein can provide a multitude of advantages in comparison to guiding devices known in the art. First of all, the web might be guided in a contact-free way. That is, when in operation, the web moves exclusively on the hover cushion without being in direct contact with the surface of the guiding device. For instance, this can be advantageous when the web could already be coated with a coating material such as amorphous silicon on that side of the web that faces the surface of the guiding device. In many applications of this case as well as in other applications, a direct contact between a surface and the coated side of the web has to be avoided. Embodiments described herein allow guiding the web along the coated side of the web in a contact-free way, i.e. without touching the coating. Note that "guiding a web" as described herein particularly comprises changing the web's moving direction and/or backing the web.

In typical applications, the pressure of the web against the cushion is in the range of 0.1 mbar and 100 mbar, more typically between 1 mbar and 10 mbar.

The shape of the surface can generally be chosen as a convex shape. The surface typically forms an elevation wherein the elevation has typically a step-free slope. In typical embodiments of the guiding device, the convex shape of the surface is elliptic in the cross-section as it is shown in Figure 1. Due to this shape the web can be guided along distances of e.g. at least 5 m or at least 10 m with the guiding device backing the web along the whole distance. The length L indicated in the Figures 1A and 1B relates approximately to the length of guiding, depending on the convexity of the surface. More precisely, the length L typically refers to the distance between the outermost gas outlets of the guiding device surface with respect to the length of the guiding device surface. In some embodiments described herein, the surface's slope is less steep in the middle region of the surface with respect to the surface's length.

In general, the guiding device according to embodiments described herein allows guiding, in particular backing a web over long distance of at least 3 m, more typically of at least 5 m or 10 m. Hence, the coating path length of the coating apparatus according to embodiments described herein can be least 3 m, more typically at least 5 m or even 10 m and more. In comparison to a drum as known in the art, the guiding device of the embodiments described herein consumes essentially less room.

Figure 1B illustrates other embodiments of the guiding device. In addition to the elements already shown with respect to the embodiments described with respect to Figure 1A, the temperature adjusting system 150 is shown. The temperature adjusting system is depicted as a spiral-wound helix for description purposes.

According to other typical embodiments, the temperature adjusting system is a system of channels disposed in the guiding device. This is exemplarily shown in Fig. 1C where the channels are referred to by reference number 160. Typically, the channels are disposed close to the surface. The term "close to" typically relates to a distance of less than 5 cm, more typically less than 2.5 cm, and even more typically less than 1 cm between the surface oriented side of the channels and the surface. The channels are typically adapted for receiving a fluid. The fluid is a fluid suitable for cooling and/or heating and shall be called cooling fluid. In particular, for temperatures up to 100°C, even more particularly for temperature below room temperature, the cooling fluid is typically a water-glycol mixture. In other applications, in particular in those applications where the surface is heated, the cooling fluid is typically a heat transfer oil. The used cooling fluid is suitable for temperatures up to typically 400°C, even more typically up to 300°C. The heat transfer oil that is typically used in embodiments described herein is made on the basis of petroleum such as naphthene or paraffm. Alternatively, the heat transfer oil can be synthetic such as an isomer composite.

In some embodiments of the methods described herein, the surface is heated up to 400°C, more typically up to 300°C, whereas in other embodiments of the methods described herein, the surface is cooled down, in particular to temperatures of up to minus 30°C, e.g. up to minus 20°C or minus 15°C.

The provision of the temperature adjusting system in combination with the multitude of gas outlets for generating a gas cushion allow for a temperature control of the web when the guiding device is in operation. In general, according to typical embodiments described herein, the guiding device is operated in vacuum. The term "vacuum" as described herein refers typically to a pressure of the order of magnitude of 10 mbar or less, more typically of 10⁻³ mbar or less. In vacuum, heat transfer can be accomplished by radiation only. Even if two objects such as the web and a surface are in direct contact to each other, there are only a few contact points between the two objects on the micro scale where a direct heat transfer can take place. Due to the missing air in vacuum, heat is hardly exchanged between those areas of the two objects that do not exactly touch each other but have a small gap in between. Hence, the main part of heat transfer between the two objects in vacuum comes from heat radiation.

Therefore, the drums known for guiding and backing a web suffer from bad temperature control capabilities. This may be overcome by embodiments described having a temperature adjusting system. By means of the temperature adjusting system the surface is kept at a specific temperature. The generated gas cushion between the surface and the web allows for a heat exchange between the surface and the web. As in all embodiments described herein, the web can be a web or a foil. Hence, the temperature of the web can be adjusted to the temperature desired.

In many embodiments of the present invention, the gas emitted in order to generate a hover cushion does not spoil the vacuum. This may be because of the low gas flow sufficient for generating the hover cushion. This may also be because the gas emitted may be used as reaction gas that has to be present in the vacuum chamber anyway. According to other embodiments, means for drawing off the gas are provided close to the surface such as an opening connected to a vacuum pump, a vacuum pump or the like.

According to embodiments described herein, a guiding device for contact-free guiding a web is provided with the device having a surface for facing the web and a multitude of gas outlets disposed in the surface wherein the multitude of gas outlets is distributed within the surface such that a gas cushion can be generated between the surface and the web when gas is emitted from the gas outlets.

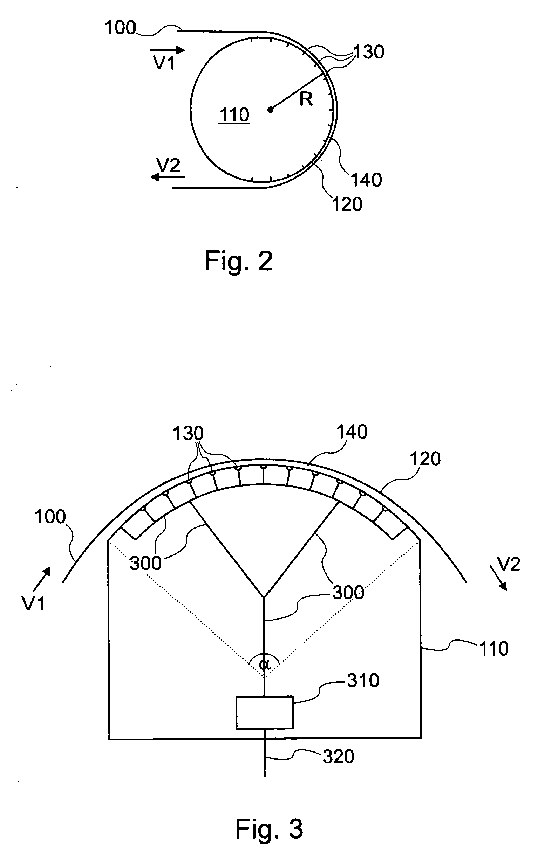

Figure 2 is a cross-sectional view illustrating other embodiments of the guiding device. The guiding device has a cylindrical shape. The embodiments described with respect to Figure 2 show the cross-section of a complete cylinder. Alternatively, the guiding device could be only a segment of a cylinder.

The guiding device 110 shown in Figure 2 guides the web 100 and changes its moving direction at 180°. According to different embodiments which can be combined with other embodiments described herein, the moving direction of the web can be changed arbitrarily. In typical embodiments, the moving direction is changed between 0° and 180°, more typically between 45° and 165°, even more typically between 90° and 160°. In the embodiment of Figure 2, the web moves with the direction V1 towards the guiding device, is then guided by the guiding device 110, and continues moving towards the direction V2. The guiding device has the surface 120 with a multitude of gas outlets 130 disposed on the surface for emitting gas from the outlets and thereby generating a hover cushion 140 between the surface 120 and the web 100.

In typical embodiments described herein, the shape of the guiding device surface is cylindrical or partly cylindrical. Hence, it is possible to assign a radius R to the cylindrical surface. In typical embodiments, the radius R lies between 5 cm and 1 m, more typically between 10 cm and 70 cm, even more typically between 20 cm and 50 cm. Other things being equal, the following relation applies: The larger the radius, the smaller the contact pressure of the web against the surface (with the hover cushion therebetween).

Figure 3 illustrates even further embodiments of the guiding device. The web 100 is guided along the partly cylindrically shaped surface 120. Thereby, the moving direction is changed from V1 to V2. In typical embodiments of the present invention having a partly cylindrical shape, the cylinder segment has a segment angle α of at least 20°, more typically of at least 45°, even more typically of at least 90°.

The surface 120 comprises a multitude of gas outlets 130 for emitting gas and thereby generating a hover cushion 140 between surface 120 and web 100. Generally, according to some embodiments described herein, the gas outlets can be holes, nozzles, spray valves, duct openings, orifices, jets, and the like. According to typical embodiments, the outlets are recesses in the surface that are typically funnel-shaped or cup-shaped with the recesses being fed with gas from the bottom of the recesses or sideways. The gas outlets of the guiding device described herein can also be openings of a porous layer. Typically, the gas outlets do not protrude out of the surface. The gas outlets are typically arranged such that the gas is emitted perpendicularly to the surface. The gas outlets are typically arranged such that the gas is emitted perpendicularly to the web. According to other embodiments, the gas outlets are arranged such that the gas is emitted in an inclined way with respect to the surface of the guiding device.

The gas feeding system 300, 310 is connected to the multitude of gas outlets. The gas feeding system is connected to a gas reservoir (not shown) by a pipe 320 or the like. The gas feeding system comprises the pressure adjuster 310 and the supplying pipes 300. According to other embodiments, the pressure adjuster 310 is replaced by a mass flow controller. Typically, the pressure adjuster or the mass flow controller are not part of the guiding device but can be provided externally.

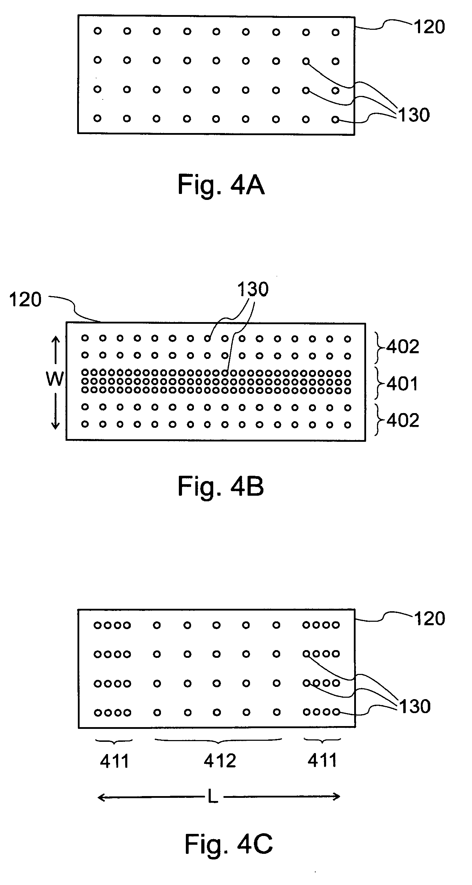

Figures 4A, 4B and 4C show schematically embodiments of the surface of the guiding device. The view of Figures 4A to 4C is as if the surface was planar. It will be understood by those skilled in the art that the surfaces shown in Figures 4A to 4C can be provided in all embodiments of the guiding device described herein and in particular in those embodiments having a partly or fully cylindrical or a partly or fully elliptic cross-sectional shape. In particular, the surfaces shown in Figures 4A to 4C can be provided in the embodiments described with regard to Figures 1A to 3 and 5 to 8.

According to the embodiment shown in Figure 4A, the gas outlets are disposed in a regular manner. The feature "disposed in a regular manner" is to be understood that the distance of an outlet and at least one neighbour outlet of it is identical to the distance of another gas outlet with respect to at least one neighbour of the other gas outlet. More typically, the feature "disposed in a regular manner" refers to a surface wherein a specific pattern can be assigned to a portion of the multitude of outlets and the same pattern can be assigned to another portion of the multitude of outlets, more typically to at least 10 other portions of the multitude of outlets, even more typically to at least 100 portions of the multitude of outlets.

The gas outlets according to the embodiment of Figure 4A are arranged in an array manner. According to many embodiments, the distances between a gas outlet and its next neighbour are identical for all gas outlets. In general, and not limited to the embodiments of Figure 4A or 4B, between 0.5 and 20, more typically between 1 and 10 gas outlets are provided per 100 cm². In typical embodiments, the distance between the gas outlets is between 10 mm and 500 mm, more typically between 50 mm and 100 mm. Generally, the diameter of the gas outlets is between 0.1 mm and 1 mm, more typically between 0.2 mm and 0.8 mm, even more typically between 0.4 mm and 0.6 mm.

According to typical embodiments of the guiding device described herein, the multitude of gas outlets comprises at least 500 gas outlets. According to typical embodiments of the methods described herein, the multitude of gas streams comprises at least 500 gas streams. Typically, according to embodiments described herein that are combinable with all other embodiments, the gas is chosen from the group consisting of hydrogen and argon.

Figure 4B illustrates further embodiments of the surface of the guiding device which can be combined with other the other embodiments described herein. Once again the gas outlets are arranged in a regular manner. Further, the gas outlets are arranged in an array manner. In contrary to the embodiment of figure 4B though, the distances between the gas outlets 130 are smaller in the middle region 401 of the surface than they are in the outer region 402 of the surface 120.

Hence, according to typical embodiments described herein that are combinable with all other embodiments, the guiding device comprises a first region having a multitude of gas outlets that are arranged in a more condensed manner than the gas outlets of a second region. In typical embodiments, the first region is arranged in the middle of the surface of the guiding device. This embodiment may be advantageous because typically a smaller amount of gas has to be introduced in order to generate the gas cushion capable of carrying the web. This is because the gas emitted from the outer region 402 of the surface can more easily flow to the edge of the surface thus not contributing to the generation of the gas cushion anymore.

According to some embodiments described herein, such as the embodiment of Fig. 4B, the distance between the gas outlets in the outer region of the surface is typically at least 1.1 times larger than the distance between the gas outlets in the middle region of the surface, more typically between 1.5 and 3 times larger. The number of gas outlets per area in the inner region of the surface is typically at least 1.1 times larger than the number of gas outlets per area of gas outlets in the middle region of the surface, more typically between 1.5 and 9 times such as between 2.25 and 9 times larger.

The typical width of the middle region having the gas outlets arranged in a more condensed manner is in the range of between 1/4 and 2/3 of the total width of the surface. The term "width of the surface" in this context refers to the distance between the outermost gas outlets with respect to the width direction of the surface. In typical embodiments, the width of the middle region 401 having the gas outlets arranged in a more condensed manner is between 20 and 80 cm, more typically between 30 and 50 cm.

Fig. 4C illustrates further embodiments of the surface of the guiding device. According to those embodiments, the surface comprises a region 411 having the gas outlets arranged in a more condensed manner than the gas outlets of another region 412. As illustrated in Fig. 4C, the region having the outlets arranged in a more condensed manner may be provided in the outer region of the guiding device surface with respect to its length L. Accordingly, the region having the outlets arranged in a less condensed manner may be provided in the middle region of the guiding device surface with respect to its length L. An arrangement as illustrated with respect to Fig. 4C may be advantageous in those applications where the web needs a stronger support in the edge regions of the guiding device surface with respect to its length. For instance, this may be useful in those embodiments where the slope of the surface is steeper in the edge region of the surface with respect to its length than it is in the middle region.

According to some embodiments described herein, such as the embodiment of Fig. 4C, the distance between the gas outlets in the middle region of the surface is typically at least 1.1 times larger than the distance between the gas outlets in the edge region of the surface, more typically between 1.5 and 3 times larger. The number of gas outlets per area in the edge region of the surface is typically at least 1.1 times larger than the number of gas outlets per area of gas outlets in the middle region of the surface, more typically between 1.5 and 9 times such as between 2.25 and 9 times larger.

The typical length of the edge region having the gas outlets arranged in a more condensed manner is in the range of between 1/10 and 1/4 of the total length of the surface. In typical embodiments, the length of the edge region 411 having the gas outlets arranged in a more condensed manner is between 5 cm and 30 cm, more typically between 10 and 20 cm.

Typically, the embodiments shown in Fig. 4B and 4C can be combined. That is, according to some embodiments described herein, the gas outlets on the surface of the guiding device can be arranged in a more condensed manner in both the middle region along the width direction (as shown in Fig. 4B) and in the edge region along the length direction (as shown in Fig. 4C).

According to typical embodiments, the gas emitted from the gas outlets is a gas having a heat conductivity of at least 0.01 W/mK, more typically of at least 0.05 W/mK, even more typically of at least 0.1 W/mK and even more typically of at least 0.15 W/mK. A typical gas chosen according to the embodiments described herein is hydrogen. Hydrogen has a heat conductivity of 0.171 W/mK. Besides, particularly in chemical vapour deposition (CVD) applications such as applied in the production of thin-film solar cell production, it is necessary to introduce hydrogen into the coating chamber anyway. For instance, in a typical CVD application, silane and hydrogen are introduced into the coating chamber. According to embodiments described herein it would be possible to introduce the hydrogen or at least part of the hydrogen via the gas outlets disposed in the surface of a guiding device disposed in the coating chamber. This might be advantageous as no extra gas spoiling the vacuum atmosphere would have to be introduced. For instance hydrogen is both useful as the gas generating the gas cushion due to its high heat conductivity and as a reaction gas with respect to the coating reaction. Further, no extra means for sealing or pumping away the emitted gas are necessary.

According to other typical embodiments, argon (Ar) is chosen as gas for generating the hover cushion. This is particularly true in those processes where argon is needed as process gas. Hence, argon is particularly typical in sputtering processes such as used for producing the transparent and conductive oxide (TCO) layer or the back contact (BC) of a thin-film solar cell.

In typical embodiments described herein, the selection of the gas used for generating the hover cushion is oriented on the following criteria: Firstly, gases used in the process are preferred. Secondly, the gas shall not have an influence on the process (as long as this influence is not intended such as in the event that the gas used for the hover cushion is also the process gas). Thirdly, the gas used shall have, if possible, high heat conductivity.

In general, embodiments described herein are designed to generate a gas cushion that is capable of carrying the web completely. The hover cushion prevents the web from having direct contact with the surface of the guiding device. In typical embodiments described, the amount of gas emitted is small enough that the gas does not spoil the specific vacuum requirements of the respective application. Hence, typically, there is no need for sealing the gas emitted from the other region, such as the coating region, or for providing specific pumps for pumping away the gas emitted.

In general, according to typical embodiments described herein, the gas used for emitting from the gas outlets can be a reaction gas of the coating such as CVD or physical vapor deposition (PVD). The coating is typically done on the front side of the web while the rear side of the web is supported by the hover cushion generated between web and guiding device surface.

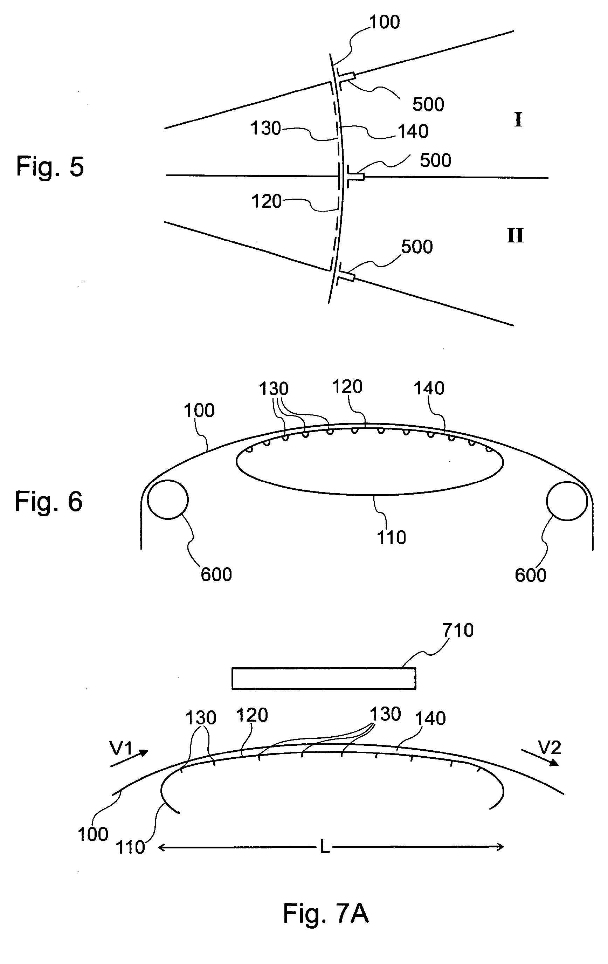

Figure 5 illustrates yet other embodiments of a guiding device. The web 100 is guided over the surface 120 having a multitude of gas outlets 130 thereby generating a hover cushion 140. The shape of the surface 120 is partly cylindrical. Further, slits 500 are arranged above the front side of the web 100. According to many embodiments which can be combined with all embodiments described herein, one or more slits can be provided by the guiding device according to embodiments described herein. The slits can be a lock such as a roller lock. Typically, the size of the slit is in the range of between 0.01 mm and 1.0 mm, more typically between 0.1 mm and 0.5 mm. In typical embodiments, the size of the slit is chosen such that there is no contact of the slit with the web.

According to typical embodiments described herein, the method comprises guiding the web through a slit arranged for separating two adjacent chambers. Further, according to typical embodiments described herein, the guiding device comprises a slit for atmospheric separation of two adjacent chambers wherein the slit is adapted for having the web passed therethrough. According to embodiments of the present invention, the slit serves to separate of two or more surface regions on the surface of the guiding device from each other. Separation in this context refers particularly to an atmosphere separation between the individual regions but may also comprise a thermal separation. For instance, in the embodiment depicted in Figure 5, the slits 500 allow a separation of the regions I and II. For instance, the gas emitted from the gas outlets on the surface belonging to region I may be different from the gas emitted from the gas outlets 130 in the surface of the region II, and a mixture of the gases has to be avoided. For example, in the event that silane is present in one region and oxygen is present in a neighboring region, a pooling of the gases would have negative consequences. Hence, according to some embodiments described herein, two or more separate gas supply channel systems may be provided in order to provide different gas to different surface regions.

For instance, in a CVD process for producing a thin-film solar cell, the separation by the provision of one or more slits is typically undertaken between regions with hydrogen and silane (e.g. for depositing the i-layer) and adjacent regions having hydrogen, silane, and additional dopants (e.g. for depositing the n-layers and p-layers). In a sputtering process for producing thin-film solar cells, the separation by the provision of one or more slits is typically undertaken between non-reactive regions with only argon present and reactive regions having additionally oxygen (02) and/or nitrogen (N2) present for reacting with the sputtered material.

In general, the separation of regions may have one or more of the following purposes. Firstly, as explained, the gases used for emitting from the gas outlets may differ from surface region to surface region. Secondly, the pressure in the regions may differ from each other due to the specific coating application that may be performed in the respective region. Thirdly, the temperature of the web desired in the several regions may differ from each other. For instance, it is possible to cool the surface in one region and to heat it up in another region. Hence, according to some embodiments described herein, two or more separately controllable temperature adjusting means may be provided in order to generate different temperature in different surface regions.

According to embodiments described herein, it is particularly easy to guide the web through the slit. Typically, the surface of the guiding device is static and the web can be guided rather exactly due to the hover cushion. This even improves the possibility of guiding the web through a slit.

Figure 6 illustrates even further embodiments of the guiding device. The guiding device 110 has an elliptic cross-section. The surface 120 is elliptic and is provided with a multitude of gas outlets 130 for generating a hover cushion 140 between the web 100 and the surface 120. For instance, the length of the major axis can be between 5 and 15 m, such as 10 m.

In general, according to different embodiments which can be combined with any of the embodiments described herein, the moving speed of the web in operation of the guiding device is between 0.1 m/min and 15 m/min, more typically between 1 m/min and 10 m/min, even more typically between 1 m/min and 5 m/min. The embodiment shown further comprises a roller 600 for guiding the web and thereby changing additionally its moving direction. One or more web guiding devices according to the present invention could be arranged alternatively or in addition to the rollers shown in Fig. 6.

In general, embodiments described herein are typically applied in one or two of the following two applications:

Firstly, in typical applications for embodiments described herein, a web is coated with a coating material on one side of the web. This side shall be called coated side or front side of the web. Typically, the web remains uncoated on the other side of the web. This side shall be called uncoated side or rear side of the web. Depending on the coating, it is desirable not to touch the coated side of the web during coating and web handling such as web guiding.

Hence it is known to guide the web with its coated side always facing away from the guiding devices. However, particularly in coating apparatuses having a long coating distance, such as in the production of thin-film solar cells, it is laborious or even impossible to arrange the web in such a way that its coated side does never face a guiding device.

Embodiments described herein allow web guiding, in particular changing the moving direction of the web arbitrarily without contacting or touching the coated web side although the coated side may face the guiding device. This is particularly advantageous in the production of thin-film solar cells where it is desirable that the deposited amorphous silicon is not touched or contacted. Hence, according to embodiments described herein, the design of the coating units and the guiding devices in a web coating apparatus is not limited any more to such arrangements where the coated side of the web must not face the guiding devices.

Secondly, as explained previously, especially in some coating applications such as the coating of positively or negatively doped amorphous silicon it is necessary to provide for a long coating distance. As explained before, due to the resulting size of a drum, it is almost impossible to use a drum for guiding and backing the web for distances of about 5 to 10 m and more. Alternatively, so-called "free-span" techniques are known where the web is not guided or backed during passing the coating distance. This technique reveals major problems with respect to the guiding properties and temperature control of the web. Embodiments described herein provide an advantageous alternative to the free-span or drum techniques by guiding the web over a gas cushion generated for this purpose without contact to the surface itself. It is typical that the uncoated side of the web faces the surface of the guiding device in those applications. Further, in typical embodiments, the surface is static and is not moved in operation of the guiding device. Hence, there is no need for moving the surface and for synchronizing this movement in order to provide for a movement of the web. Further, the surface of the web guiding device according to embodiments described herein can also have a non-cylindrical surface shape.

Figure 7A illustrates even further embodiments of a coating apparatus. Further to the guiding devices already described with respect to Figure 1A, a coating tool 710 is schematically depicted above the web 100. In general, according to different embodiments that can be combined with all embodiments described herein, the coating tool according to embodiments described herein may comprise the devices for CVD, PVD, even plasma enhanced chemical vapour deposition (PECVD) or sputtering. Coating may be performed by evaporating material or sputtering.

Typically, the coating apparatus may provide for vacuum generating means such as a vacuum pump system, one or more vacuum pumps or one or more outlets for drawing off the gases present such as the process gas and the gas provided for generating the hover cushion. Typically, coating is performed in a vacuum atmosphere with pressures of less than 1 mbar, more typically of less than 10 mbar, even more typically less than 10⁻³ mbar.

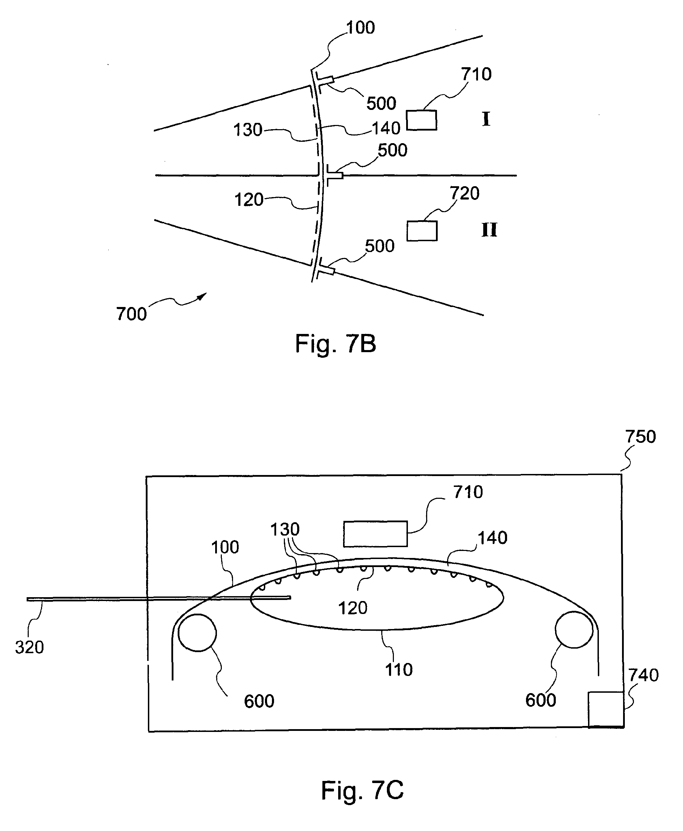

Figure 7B shows further embodiments of a coating apparatus. Further to the elements already shown in Figure 5, the coating apparatus 700 comprises coating tools 710 and 720. The coating tool 710 is situated in the region I and the coating tool 720 is situated in the region II above the surface 120. As already explained with respect to the embodiment of Figure 5, it is possible that the guiding device and the coating apparatus provide several regions that are separated from each other by, for example, a slit 500. The separation of several regions in the guiding device or coating apparatus in typically between 2 and 10, more typically between 2 and 5, even more typically between 2 and 3 regions, allows to perform different coating steps on the same web guiding device. This is particularly interesting in applications where the coating length per coating step is in the range of 1 m or below. This is also particularly interesting in those applications where several layers of different material are coated on the web. In general, the coating tools of the different regions can be arbitrarily chosen. For instance, it is possible that the coating tool of one region is for sputtering whereas the coating tool of the other region is for evaporation. In typical embodiments described herein, however, the coating tools of the multitude of regions are evaporators.

Figure 7C shows another embodiment of a coating apparatus. Further to the elements already described with respect to Figure 6, the coating apparatus comprises the coating tool 710 arranged above the surface. Typically, the coating tool is arranged above the front side of the web. In general, it is possible that several coating tools are arranged in the coating apparatus according to the present invention. According to some embodiments, the several coating tools can be arranged along the moving direction of the web. Alternatively or in addition, the several coating tools can be arranged perpendicularly to the moving direction of the web.

The gas supply tube 320 supplies gas for emitting it from the gas outlets. As in all the other embodiments described herein and other embodiments described herein, a temperature adjusting system could be provided within the guiding device in order to control the temperature of the guided web. The temperature adjusting system can be, for instance, a channel system for receiving cooling fluid. Further, a vacuum generating system 740 is shown in the coating apparatus according to Figure 7C that can be an outlet of the chamber 750 of the coating apparatus for pumping out air from the coating apparatus. Alternatively or in addition, the vacuum generating system can be a vacuum pump.

As explained previously, the guiding device, the coating apparatus, the method for contact-free guiding a web, and the method for coating a web can be particularly applicable in the production of thin-film solar cells. The thin films are typically deposited by CVD, in particular PECVD, from silane gas and hydrogen yielding to amorphous silicon or protocrystalline silicon or nanocrystalline silicon. The silicon layer is typically sandwiched by a back contact such as a metal and a transparent and conductive oxide (TCO) layer.

A typical method for producing a thin-film solar cell comprises depositing a back contact on the web, depositing an absorbing layer such as amorphous silicon or the like, and depositing a TCO layer. Each depositing can comprise several sub steps. For instance, the deposition of amorphous silicon has to follow a predetermined sequence of positively doped, negatively doped, and intrinsic (non-doped) silicon layers. Dependent on the design of the solar cell, the solar cell may comprise several negatively doped layers and/or several positively doped layers and/or several intrinsic layers. Embodiments described herein can be particularly advantageous in the production of thin-film solar cells since a contact of the coated side of the web with any guiding means has to be prevented in order not to damage any deposited layer.

It is further typical in the production of a solar cell to coat the TCO layer with a protective layer. The typical coating process for the back contact is sputtering. The typical coating process for coating the absorbing layer that is typically made of amorphous silicon is a CVD or PECVD process. The typical coating process for coating the TCO layer is sputtering. In general, CVD is typically accomplished under a pressure in the range of between 1 mbar and 100 mbar. Sputtering is typically accomplished under a pressure of between 10⁻² mbar and 10⁻⁴ mbar.

While the foregoing is directed to embodiments of the invention, other and further embodiments of the invention may be devised without departing from the basic scope thereof, and the scope thereof is determined by the claims that follow.

## Claims

1. Guiding device (110) for contact-free guiding a web (100) in a web coating process, the guiding device having
- a surface (120) for facing the web; and
- a multitude of gas outlets (130) disposed in the surface and adapted for providing a hover cushion for the web.

2. Guiding device (110) according to claim 1 wherein the multitude of gas outlets is distributed within the surface such that a hover cushion (140) can be generated between the surface and the web when gas is emitted from the gas outlets with the hover cushion being adapted for carrying the web.

3. Guiding device according to claim 1 or 2 wherein the surface is non-rotatable.

4. Guiding device according to any of the preceding claims wherein the surface (120) is shaped such that the moving direction (V1;V2) of the web is changed.

5. Guiding device according to any of the preceding claims wherein the surface has a convex shape.

6. Guiding device according to any of the preceding claims wherein the surface has a non-cylindrical cross-section.

7. Guiding device according to any of the preceding claims wherein the shape of the surface is a segment of a cylinder, an oval, or an ellipse.

8. Guiding device according to any of the preceding claims further having a temperature adjusting system (150; 160).

9. Guiding device according to claim 8 wherein the temperature adjusting system comprises channels (160) for receiving a fluid.

10. Guiding device according to any of the preceding claims wherein the multitude of gas outlets comprises between 1-10 gas outlets per 100 cm².

11. Guiding device according to any of the preceding claims wherein the multitude of gas outlets is arranged as an array of gas outlets of the multitude of gas outlets.

12. Apparatus for coating a web having a guiding device according to any of the preceding claims.

13. System comprising a guiding device according to any of claims 1 to 11 and a web, the web having a coated side wherein the coated side faces the surface of the guiding device.

14. Method for contact-free guiding a web comprising:
- moving the web over a surface; and
- emitting a multitude of gas streams from the surface thereby generating a hover cushion between the surface and the web.

15. Method according to claim 14 wherein the surface is static.

16. Method according to claim 14 or 15 wherein guiding comprises changing the moving direction of the web.

17. Method according to any of claims 14 to 16, wherein the web has a coated side, the method further comprising arranging the web with the coated side facing the surface.

18. Method according to any of claims 14 to 17 wherein moving the web over the surface is conducted along a curved path.

19. Method according to claim 18 wherein the web is moved over a convex surface which is a segment of a cylinder or an ellipse.

20. Method according to any of claims 14 to 19 further comprising the step of cooling or heating the web.

21. Method according to any of claims 14 to 20 wherein the gas is chosen as having a heat conductivity of at least 0.1 W/mK.

22. Method according to any of claims 14 to 21 wherein the multitude of gas streams are arranged in an array.

23. Method for coating a web comprising a method according to any of the claims 14 to 22, further comprising coating the web

24. Method according to claim 23 wherein coating the web comprises depositing amorphous silicon on the web.

25. Method for producing a thin-film solar cell comprising a method according to any of the claims 14 to 24 and
- depositing a back contact on the web; and
- depositing a transparent and conductive oxide layer.

## Amended claims

### Amended claims in accordance with Rule 137(2) EPC.

**1.** Guiding device (110) for contact-free guiding a web (100) in a web coating process in a vacuum atmosphere, the guiding device having
- a surface (120) for facing the web; and
- a multitude of gas outlets (130) disposed in the surface and adapted for providing a hover cushion for the web, wherein the hover cushion comprises a process gas.

**2.** Guiding device (110) according to claim 1 wherein the multitude of gas outlets is distributed within the surface such that a hover cushion (140) can be generated between the surface and the web when gas is emitted from the gas outlets with the hover cushion being adapted for carrying the web.

**3.** Guiding device according to claim 1 or 2 wherein the surface is non-rotatable.

**4.** Guiding device according to any of the preceding claims wherein the surface (120) is shaped such that the moving direction (V1;V2) of the web is changed.

**5.** Guiding device according to any of the preceding claims wherein the surface has a convex shape.

**6.** Guiding device according to any of the preceding claims wherein the surface has a non-cylindrical cross-section.

**7.** Guiding device according to any of the preceding claims wherein the shape of the surface is a segment of a cylinder, an oval, or an ellipse.

**8.** Guiding device according to any of the preceding claims further having a temperature adjusting system (150; 160).

**9.** Guiding device according to claim 8 wherein the temperature adjusting system comprises channels (160) for receiving a fluid.

**10.** Guiding device according to any of the preceding claims wherein the multitude of gas outlets comprises between 1-10 gas outlets per 100 cm².

**11.** Guiding device according to any of the preceding claims wherein the multitude of gas outlets is arranged as an array of gas outlets of the multitude of gas outlets.

**12.** Apparatus for coating a web having a guiding device according to any of the preceding claims.

**13.** System comprising a guiding device according to any of claims 1 to 11 and a web, the web having a coated side wherein the coated side faces the surface of the guiding device.

**14.** Method for contact-free guiding a web in a vacuum atmosphere comprising:
- moving the web over a surface; and
- emitting a multitude of gas streams from the surface thereby generating a hover cushion between the surface and the web, wherein the hover cushion comprises a process gas.

**15.** Method according to claim 14 wherein the surface is static.

**16.** Method according to claim 14 or 15 wherein guiding comprises changing the moving direction of the web.

**17.** Method according to any of claims 14 to 16, wherein the web has a coated side, the method further comprising arranging the web with the coated side facing the surface.

**18.** Method according to any of claims 14 to 17 wherein moving the web over the surface is conducted along a curved path.

**19.** Method according to claim 18 wherein the web is moved over a convex surface which is a segment of a cylinder or an ellipse.

**20.** Method according to any of claims 14 to 19 further comprising the step of cooling or heating the web.

**21.** Method according to any of claims 14 to 20 wherein the gas is chosen as having a heat conductivity of at least 0.1 W/mK.

**22.** Method according to any of claims 14 to 21 wherein the multitude of gas streams are arranged in an array.

**23.** Method for coating a web comprising a method according to any of the claims 14 to 22, further comprising coating the web

**24.** Method according to claim 23 wherein coating the web comprises depositing amorphous silicon on the web.

**25.** Method for producing a thin-film solar cell comprising a method according to any of the claims 14 to 24 and
- depositing a back contact on the web; and
- depositing a transparent and conductive oxide layer.
